## Europäisches Patentamt

## European Patent Office

## Office européen des brevets

(19)

(11) Publication number: **0 006 025**
**B1**

(12)

# EUROPEAN PATENT SPECIFICATION

(45) Date of publication of patent specification: **19.01.83**

(51) Int. Cl.³: **H 01 L 31/18**

(21) Application number: **79301038.0**

(22) Date of filing: **01.06.79**

(54) Process for manufacturing a thin-film CdS/CdTe photovoltaic cell having enhanced conversion efficiency and photovoltaic cell produced by this process.

(30) Priority: **02.06.78 US 911843**

(43) Date of publication of application:
**12.12.79 Bulletin 79/25**

(45) Publication of the grant of the patent:
**19.01.83 Bulletin 83/3**

(84) Designated Contracting States:
**DE FR GB**

(56) References cited:
**DE - A - 2 535 507**
**DE - C - 2 141 212**
**US - A - 4 035 197**

**Applied Physics Letters, Vol. 30, Nr. 8, 15 April 1977 New York**
**YALE Y. MA et al., "Photovoltaic properties of n-CdS/p-CdTe heterojunctions prepared by spray pyrolysis, pages 423—424.**

The file contains technical information submitted after the application was filed and not included in this specification

(73) Proprietor: **EASTMAN KODAK COMPANY**
**343 State Street**
**Rochester, New York 14650 (US)**

(72) Inventor: **Tyan, Yuan-Sheng**
**Kodak Park**
**Rochester New York (US)**

(74) Representative: **Pepper, John Herbert et al,**
**KODAK LIMITED Patent Department P.O. Box 114**
**190 High Holborn**
**London WC1V 7EA (GB)**

(56) References cited:
**9th. IEEE Photovoltaic Specialist Conference 1972**
**D. BONNET et al., "New results on the development of a thin-film p-CdTe-n-CdS heterojunction solar cell," pages 129—132.**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

# Process for manufacturing a thin-film CdS/CdTe photovoltaic cell having enhanced conversion efficiency and photovoltaic cell produced by this process

This invention relates to thin-film p-n cadmium telluride-cadmium sulfide photovoltaic cells.

In Bonnet, "New Results on the Development of a Thin-Film p-CdTe-n-CdS Heterojunction Solar Cell," 9th IEEE Photovoltaic Specialist Conference, P. 129 (1972), there is reported a thin-film cell of CdS/CdTe in the polycrystalline condition. The conversion efficiency of this cell was reported by Bonnet to be 5%. However, a review of his calculations reveals that the conversion efficiency of this cell was actually less than the reported value of 5%.

Photovoltaic cells having polycrystalline cadmium sulphide and polycrystalline cadmium telluride in contiguous layers allow the inexpensive layered formation of a truly thin cell, inasmuch as the combined thickness of two layers of polycrystalline semiconductor need not exceed 100 microns, and preferably does not exceed 10 microns. Such thin-film CdS/CdTe photovoltaic cells are presently limited in their conversion efficiency to less than 5%.

The present invention is based upon the discovery that the conversion efficiency of thin-film, polycrystalline CdS/CdTe cells can be significantly enhanced if either (or both) of the layers of CdS and CdTe is deposited under conditions such that at least a small amount of oxygen is present in the atmosphere through which the CdS or CdTe passes while its respective layer is being deposited. The present process involves a close-space sublimation technique in the steps that involve deposition of the CdS and CdTe layers. Thin-film polycrystalline CdS/CdTe cells having conversion efficiencies of at least 6% can be manufactured using this process. DE—C—2141212 discloses a method of manufacturing a thin layer of a photoconductive group II—VI compound, e.g. CdS or CdTe which may be used as a solar cell. After heat treatment in an atmosphere containing oxygen, oxygen is apparently incorporated into the layer.

Fig. 1 is a plot of conversion efficiencies achieved by cells of the invention, versus the substrate temperature used during the formation of the respective CdTe layers.

Fig. 2 is a partially schematic section view of a cell prepared in accordance with the invention.

Enhancement of the conversion efficiency of a photovoltaic cell having polycrystalline CdS and polycrystalline CdTe in contiguous layers is achieved by forming one or both of these layers in an oxygen-containing atmosphere. Maximum enhancement occurs when the layers are formed within a preferred range of temperatures in the presence of gaseous oxygen.

As used herein, "enhanced conversion efficiency" means a conversion efficiency that is more than 10% greater than the conversion efficiency of an otherwise identical control cell produced in an oxygen-free atmosphere during the formation of the CdS and/or the CdTe layer(s).

The process of this invention involves forming the CdS and/or the CdTe polycrystalline layers using an atmosphere which contains oxygen. In the process, the layers of CdS and CdTe are deposited in the vapour phase. As used herein, "close-space sublimation" means sublimation from a source to a substrate positioned from the source a distance no greater than the square root of the smaller of the surface areas of the source or of the substrate. Thus, the manipulative steps of the process of this invention are known. What was not known heretofore is the use of oxygen in the atmosphere through which CdS and/or CdTe passes during the step which involves the vapour deposition of polycrystalline layers of such photoconductors.

During the vapour deposition step, the atmosphere through which CdS or CdTe passes from the source to the substrate can be either pure oxygen or oxygen admixed with other gases, such as air.

In the process of this invention, CdS is preferably deposited from the vapour phase on a suitable electrode, described below, with or without oxygen present in the atmosphere. Thereafter, cadmium telluride and, optionally, a p-type dopant such a gold are similarly deposited in the vapour phase on the previously formed layer of cadmium sulphide, with or without oxygen present in the atmosphere, except that at least one of these two layers is deposited in the presence of oxygen gas.

Thereafter, an electrode capable of making a low impedance contact is formed on at least a portion of the layer of cadmium telluride. A preferred process for the formation of this electrode is vacuum deposition.

The vapour phase deposition of the CdS and CdTe can be done as a batch process, e.g., in a vacuum chamber containing a single source and a single substrate, or as a continuous process in which a substrate is moved through appropriate zones for treatment.

Close-space sublimation is one form of vapour-phase deposition in the practice of this invention. The oxygen in the atmosphere during the sublimation can be at a partial pressure between 0.01 and 100 torr (1.33 and 13300 Pa), and preferably is at a partial pressure between 0.1 and 10 torr (13.3 and 1333 Pa). The spacing between source and substrate preferably is between 0.5 and 5 mm. The temperature of the substrate upon which each of the semiconductor layers is to be deposited can be varied, depending on which material is being sublimed. Preferably, the deposition of each of the CdS and CdTe is conducted from 0.1 sec to 10 minutes onto a substrate held at a temperature of between 300°C and 650°C. The source temperature is maintained in each instance between 10°C and 500°C (preferably 100—300°C) higher than the substrate temperature during the CdS deposition and preferably 20—50°C higher than the substrate during the CdTe deposition.

Using close-space sublimation in accordance with the practice of this invention, higher conversion efficiencies are achieved when the CdTe layer is sublimed in an oxygen-containing atmosphere on a CdS substrate at a temperature of at least 575°C, the CdS layer also having been sublimed in an atmosphere that contained oxygen.

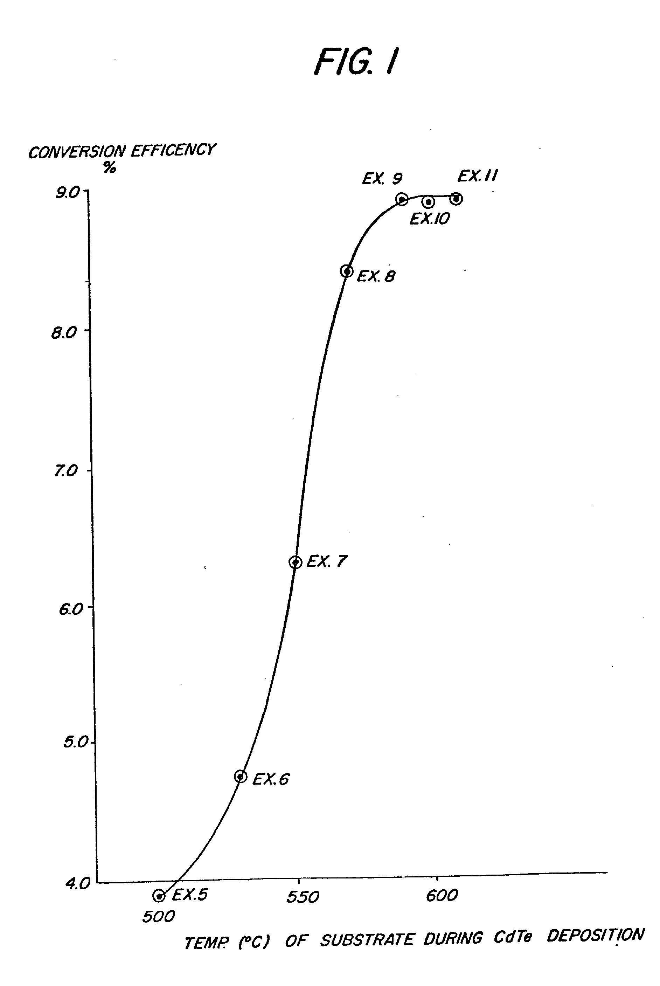

One effect of deposition temperature is illustrated in Fig. 1. The CdS substrate in this case was also sublimed in an atmosphere that contained 0.4 torr oxygen. Each data point in Fig. 1 represents a separate cell wherein the only difference in the preparation of the cell was the temperature of the CdS substrate during the CdTe deposition. Whereas the use of a substrate temperature of 500°C resulted in a conversion efficiency of 3.9%, increasing the temperature of the substrate to 550°C raised the conversion efficiency to 6.3%, while increasing the temperature to 570°C raised it still further, to 8.4%. A further increase in temperature of the CdS substrate to 600°C resulted in a further increase in efficiency to 8.9%.

It is possible that the temperature of the CdS substrate above which further substantial increases in conversion efficiency are apparently not achievable can be lowered below 575°C if other variables of the sublimation process are further optimized.

Further enhancement of the conversion efficiency of the CdS/CdTe cells can be achieved by an optional process step of heating the formed CdTe layer in an oxygen-containing atmosphere for a suitable length of time. Oxygen under ordinary or high pressure can be used, such as air at ambient pressure. Partial pressure of oxygen can also be used in this optional step, as can an alternating non-oxidizing and oxidizing atmosphere of the type described in U.S. Patent No. 4,035,197, and stated to increase the conversion efficiency of a cadmium telluride photovoltaic cell. The temperature of such post-treatment can be between 100°C and 600°C, for a time of between 1 second and 20 minutes.

Such post-heating of the CdTe layer can increase the conversion efficiency by 1 or 2% over that achieved by the same cell lacking the post-heating step.

It is believed that the vapour deposition of one or both of the semiconductor materials in an oxygen-containing atmosphere produces enhanced conversion efficiencies by the incorporation of oxygen atoms into the semiconductor layer. The exact amounts of such oxygen incorporation are so minute that they are difficult to detect or assay.

To complete the cell, electrodes are selected to provide low-impedance contact with at least portions of the exterior surface of each of the two contiguous semiconductor layers. As used herein, "low impedance" means an impedance that is no greater than that which gives a contact resistance of 50 ohm cm². Although such low-impedance contacts at least approach a true ohmic contact, some rectification in the contact can also be tolerated.

Each of the electrode is in operative contact with its respective layer; that is, in the cell it contacts only its layer. At least one of the electrodes is sufficiently transparent to transmit sufficient radiation to photogenerate an electric potential in the cell. Conveniently, such transmission of radiation is accomplished by rendering one of the electrodes transparent to at least some radiation having wavelengths between 350 and 900 nm. A useful material having this property is "Nesatron" brand glass, available from PPG Industries, Inc., "Nesatron" is the Trade Mark for transparent glass electrode comprising a thin layer of conductive $In_2O_3(Sn)$ coated on transparent glass. Such an electrode typically has a sheet resistance of 10 to 50 ohm/square and an optical transmittance of 80% for visible light. The "Nesatron" electrode provides a low-impedance contact with the n-type cadmium sulphide, and thereby provides a highly useful substrate for the first semiconductive layer. Other conventional electrodes also can be selected, providing they have sufficient conductivity, light transmittance, and the capability of forming the desired low-impedance contact with n-type CdS. Examples include transparent layers of CdO, $SnO_2$ and $Cd_2SnO_4$, on glass, with or without dopants.

Electrodes for low-impedance contact with the p-type CdTe can be, for example, gold, silver, copper, nickel, tin, platinum, palladium, chromium, iridium, rhodium, and non-metallic materials such as $Cu_2S$ and $Cu_2Te$ having high electrical conductance and a work function approximately matching that of p-CdTe.

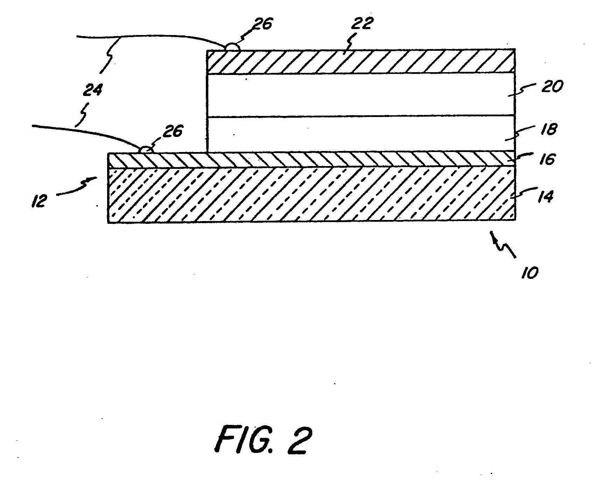

Fig. 2 illustrates a typical photovoltaic cell 10 produced in accordance with the process of the invention. Transparent electrode 12 comprises a support layer 14 of glass bearing a conductive layer 16 of $In_2O_3(Sn)$, on which is formed layer 18 of n-type CdS. A contiguous layer 20 of p-type CdTe is formed on the layer 18, and an electrode layer 22 contacts at least a portion of the layer 20. Leads 24 attached by solder 26 carry away power from the cell. Because the layers 18 and 20 are polycrystalline, they can be prepared so that they are extremely thin, for example, no greater than 50 microns (50 $\mu$m) thick and preferably from 0.05 to 5 microns (0.05 to 5 $\mu$m) thick. The total thickness then of the combined semiconductor layers 18 and 20 is generally less than 100 microns (100 $\mu$m), and preferably no greater than 10 microns (10 $\mu$m).

The electrode layers 16 and 22 are extremely thin being from 100 to 1000 nm and from 3 to 100 nm, respectively. The glass support layer 14 is typically 1000 microns thick.

Photovoltaic cells manufactured by the process of this invention can be used to photogenerate electric power; e.g., when exposed to activating radiation. In such use, the potential created across the junction between the CdS and CdTe layers can be used as a voltage source, or the current generated by the cell can be drawn off. Thus, among other things, the cell can be used as a voltage generator or as an exposure meter operating from the cell's short circuit current.

The following examples further illustrate the invention. Except where noted, pure oxygen atmospheres at stated partial pressures were used. In each example simulated sunlight illumination of 75 mW/cm² was achieved by using a Kodak "Carousel" projector, Model 600, with the heat-absorbing glass removed, and containing a 500 W tungsten lamp, and a spectrum-correcting filter. 'Kodak' and 'Carousel' are Trade Marks. Conversion efficiencies were calculated from the measured $I_{sc}$, $V_{oc}$, fill factor and the known input illumination. As used herein, "fill factor" means the fraction of the product of $I_{sc}$ and $V_{oc}$ that is available as power output for the cell. In these examples, the space between the source and the substrate during the deposition of the CdS or CdTe layer was approximately 2 mm.

## Example 1

A cell was prepared of the type shown in Fig. 2, as follows:

On a 1 mm thick "Nesatron" glass substrate a 0.2 micron (200 nm) thick layer of CdS was deposited at a temperature of 550°C, in an oxygen-containing atmosphere of 0.4 torr (53.3 Pa) oxygen. The temperature of the CdS source was 700—720°C. A 2 microns ($2\mu$m) thick layer of CdTe was then deposited on the CdS layer while it was heated at a temperature of 590°C, in an atmosphere containing 1.5 torr (200 Pa) oxygen and 1.5 torr (200 Pa) Argon. The temperature of the CdTe source was 650°C. A 500 nm thick gold electrode layer 6 was vacuum-deposited on the CdTe layer. Under simulate sunlight illumination of 75 mW/cm², the cell had a $V_{oc}$ of 0.7 volts, an $I_{sc}$ of 16 mA/cm², and a fill factor of 0.6. The conversion efficiency was 8.9%.

## Example 2
### Enhancement When Oxygen is Present Only During Deposition of the CdS Layer

To demonstrate the effect of the use of an oxygen-containing atmosphere only during the deposition of the CdS layer, a control cell and 5 test cells were prepared as follows: "Nesatron" substrates having a nominal resistivity of 25 ohm/square were cleaned. The CdS layer was then deposited by close-space sublimation, wherein the source was a hot-pressed disc of phosphor-grade CdS powder obtained from the General Electric Company. The process was carried out with a source temperature of 750°C and a substrate temperature of 535°C. In the case of the control cell, a vacuum (less than 0.01 torr (1.33 Pa) oxygen) was used. The five test cells, on the other hand, incorporated pure oxygen at a pressure of 2.5 torr (333 Pa) while the CdS was being sublimed. The time for CdS deposition was 2 to 4 minutes, leading to a layer of CdS between 1 micron and 2 microns thick. After cooling the substrate to near room temperature, it was placed on another holder for the deposition of CdTe. The source was a polycrystalline disc sliced from an ingot which had been prepared by reacting 99.9999% pure Cd and Te in a melt doped with 10 ppm of Au. A source temperature of 550°C, a substrate temperature of 450°C and a deposition time of 2 minutes were used to deposit a layer of CdTe 0.5 microns thick. The deposition of the CdTe layer was carried out in a vacuum in the essential absence of oxygen. The CdS/CdTe resulting structure was then heated in air at 325°C for 3 minutes, after which the cell was completed by vapor-depositing a 500 Å (50 nm) thick layer of Au on the layer of CdTe.

The photovoltaic response of the control cell (wherein both the CdS layer and the CdTe layer had been deposited in the absence of oxygen) was $V_{oc} = 0.37$, $I_{sc} = 7.1$ mA/cm², fill factor of 0.4 and coversion efficiency = 1.38%. In contrast, the average photovoltaic response of the 5 test cells was $V_{oc} = 0.48 \pm 0.03$ mV, $I_{sc} = 9.1 \pm 1.6$ mA/cm², fill factor of 0.4, and conversion efficiency = 2.5 + 0.3%, an improvement in conversion efficiency of more than 1%.

## Examples 3 and 3A

To further illustrate the effect of the presence or absence of oxygen during the deposition of the layer of CdS, two cells were made with the layer of CdS deposited in the presence of air at two different pressures. One of the cells, Example "3", was prepared by subliming the CdS layer in a vacuum of less than 0.01 torr (1.33 Pa). Sublimation was accomplished with the source and the substrate separated by 2 mm. The layer of CdTe was formed by sublimation for 2 min onto the CdS substrate which was maintained at a temperature of 610°C in an atmosphere of 1.5 torr (200 Pa) oxygen and 1.5 torr (200 Pa) Argon. The temperature of the source was 630°C. Example 3A was prepared identically as Example 3, except that air, at a pressure of 0.15 torr (20 Pa), was used as the atmosphere for the sublimation of the CdS. Table 1 illustrates the results.

Table 1

| Example | Air Pressure, During Deposition of the CdS Layer, Torr | $\eta$, % | $V_{oc}$, mV | $I_{sc}$, mA/cm² | FF |
|---|---|---|---|---|---|
| 3 | essentially zero | 4.0 | 390 | 15.1 | 0.51 |
| 3A | 0.15 | 8.3 | 650 | 17.0 | 0.56 |

Very little improvement in conversion efficiency was noted upon increasing the air pressure above 0.15 torr (20 Pa). This example demonstrated that although the presence of oxygen in the atmosphere for the deposition of the layer of CdTe produced a significant enhancement of conversion efficiency, an even higher value is achieved if oxygen is also present for deposition of the layer of CdS.

Example 4
Enhancement When Oxygen is Present only During Deposition of the CdTe Layer
To demonstrate the enhancement achievable by depositing only the layer of CdTe in the presence of oxygen gas, eight cells were prepared by the procedure of Example 2 on layers of CdS prepared as in Example 2. Then the layer of CdTe was deposited using an atmosphere having a partial pressure of oxygen equal to 5.0 torr. These eight cells showed an average $V_{oc}$ of $0.618_2 \pm 0.012$ volts, an average $I_{sc}$ of $11.5 \pm 1.5$ mA/cm², a fill factor of approximately $0.5 + 0.01$, and an average conversion efficiency of $4.89 \pm 0.54\%$. Thus, an improvement of more than 2% in conversion efficiency was achieved by depositing the CdTe in the presence of an atmosphere which contained oxygen.

Examples 5—11
To demonstrate the effect of the substrate temperature for the deposition of the CdTe, seven cells were made under the following conditions: a thin layer of CdS was deposited by close-space sublimation on a "Nesatron" glass substrate having a nominal electrical resistance of 10 ohm/square. The temperature of the source was 720°C and the temperature of the substrate was 550°C. The time for CdS deposition was 5 seconds. The CdS deposition was carried out in oxygen at a pressure of 0.4 torr (53.3 Pa). Then a layer of CdTe was deposited by the close-space sublimation procedure. The temperature of the source was 630°C to 640°C. The temperature of the substrate was varied as shown in Table II. The time for CdTe deposition was 2 minutes. The CdTe deposition was carried out in an atmosphere consisting essentially of 1.5 torr (200 Pa) Oxygen and 1.5 torr (200 Pa) Argon. Cell manufacture was completed by deposition on the layer of CdTe of a 500 Å (50 nm) thick layer of gold, using the technique of conventional vacuum evaporation under a pressure of $10^{-6}$ torr. (For the cells with 600°C or higher substrate temperature, a slightly higher source temperature was used to provide a layer of CdTe having a thickness similar to that of the other cells). The results are summarized in Table II, and represent the data points in Fig. 1.

Table II

| Example | CdTe Deposition Source Temp., °C | CdTe Deposition Substrate Temp., °C | $\eta$, % | $V_{oc}$, mV | $I_{sc}$, mA/cm² | FF |
|---|---|---|---|---|---|---|
| 5 | 630 | 500 | 3.9 | 560 | 12.5 | 0.42 |
| 6 | 630 | 530 | 4.7 | 610 | 13.7 | 0.43 |
| 7 | 630 | 550 | 6.3 | 630 | 14.7 | 0.50 |
| 8 | 630 | 570 | 8.4 | 680 | 16.7 | 0.55 |
| 9* | 630 | 590 | 8.9 | 705 | 16.3 | 0.58 |
| 10 | 640 | 600 | 8.9 | 695 | 16.7 | 0.58 |
| 11 | 644 | 610 | 8.9 | 710 | 16.5 | 0.58 |

*This is the cell described in Example 1.

Example 12

To further illustrate the effect of the presence of oxygen during deposition of a layer of CdTe, a series of cells was prepared by varying the oxygen pressure during the deposition of CdTe while the other process conditions were kept essentially constant. The deposition of the CdS was carried out in an atmosphere having 0.4, 0.5 or 1.0 torr (53.3 66.7 or 133 Pa) oxygen, using a $T_{source}$ (source temperature) of 710, 720 or 725°C and a $T_{substrate}$ (substrate temperature) of 500°C or 550°C. The CdTe deposition used a $T_{source}$ of 630 or 640°C and a $T_{substrate}$ of 600 or 610°C. None of these minor variations are believed to have a significant effect on the conversion efficiencies of the resulting CdS/CdTe cells.

It was found that the cell produced in the presence of oxygen (during CdTe deposition) at a partial pressure of 0.5 torr (66.7 Pa) had a conversion efficiency of 4.6%, whereas cells produced in the presence of oxygen at a partial pressure of about 1.0 torr (13.3 Pa) or higher, gave conversion efficiencies which were generally constant at 8.75% ± 1.25.

**Claims**

1. A process for manufacturing a thin-film photovoltaic cell, which process comprises, in separate steps, depositing by close-space sublimation, contiguous layers of polycrystalline n-type cadmium sulphide and polycrystalline p-type cadmium telluride, characterized in that at least one of the layers is deposited in the presence of oxygen gas whereby one cell has enhanced conversion efficiency.

2. A process as claimed in Claim 1, wherein the partial pressure of the oxygen is from 1.33 to 13300 pascals.

3. A process as claimed in Claim 2, wherein the oxygen gas is present during both of the separate steps.

4. A process as claimed in any of the preceding Claims wherein the cadmium telluride is deposited on a layer of the cadmium sulphide at a temperature of at least 550°C.

5. A process as claimed in any of the preceding Claims wherein the partial pressure of the oxygen gas is from 13.3 to 1330 pascals.

6. A process as claimed in Claim 5, wherein said layer of cadmium sulphide is deposited on a transparent support.

7. A process as claimed in any of the preceding Claims wherein the process includes the step of heating either or both of the deposited layers in the presence of an atmosphere containing oxygen until the conversion efficiency of the resulting cell is additionally enhanced.

8. A thin film photovoltaic cell comprising first and second contiguous layers (18, 20) containing, respectively, polycrystalline n-type cadmium sulphide and polycrystalline p-type cadmium telluride, and electrodes (12, 22) in operative, low impedance contact with said layers, characterized in that at least one of said electrodes is transparent to visible light, the combined thickness of said layers being at most 10 microns, and that oxygen is incorporated into at least one of said layers in an amount that the conversion efficiency of said photovoltaic cell is at least 6%.

**Revendications**

1. Procédé de fabrication d'une cellule photovoltaïque à couches minces, consistant à déposer successivement, par une technique de sublimation à courte distance, des couches adjacentes de sulfure de cadmium polycristallin de type-n et de tellurure de cadmium polycristallin de type-p, procédé caractérisé en ce qu'on dépose au moins l'une des couches en présence d'oxygène gazeux, permettant ainsi d'obtenir une cellule qui présente un rendement de conversion accru.

2. Procédé conforme à la revendication 1, caractérisé en ce que la pression partielle de l'oxygène est comprise entre 1,33 Pa et 13 300 Pa.

3. Procédé conforme à la revendication 2, caractérisé en ce qu'on dépose les deux couches en présence d'oxygène gazeux.

4. Procédé conforme à l'une quelconque des revendications 1 à 3, caractérisé en ce qu'on dépose le tellurure de cadmium sur une couche de sulfure de cadmium à une température d'au moins 550°C.

5. Procédé conforme à l'une quelconque des revendications 1 à 4, caractérisé en ce que la pression partielle de l'oxygène est comprise entre 13,3 Pa et 1 330 Pa.

6. Procédé conforme à la revendication 5, caractérisé en ce qu'on dépose la couche de sulfure de cadmium sur un support transparent.

7. Procédé conforme à l'une quelconque des revendications 1 à 6, caractérisé en ce qu'il comprend une étape de chauffage de l'une des couches déposées ou des deux couches déposées, en présence d'une atmosphère contenant de l'oxygène, jusqu'à ce qu'on obtienne un accroissement supplémentaire du rendement de conversion de la cellule résultante.

8. Cellule photovoltaïque à couches minces comprenant une première et une deuxième couches adjacentes (18, 20), contenant, respectivement, du sulfure de cadmium polycristallin de type-n, et du tellurure de cadmium polycristalline de type-p et des électrodes (12, 22) placées en contact efficace, et de faible impédance, avec les dites couches, caractérisée en ce que l'une au moins des dites électrodes

## 0 006 025

est transparente à la lumière visible, l'épaisseur de l'ensemble des dites couches étant au plus égale à 10μm, et en ce que de l'oxygène est incorporé dans au moins l'une des couches à une concentration telle que le rendement de conversion de cette cellule photovoltaïque est au moins égal à 6%.

**Patentansprüche**

1. Verfahren zur Herstellung eines Dünnschicht-Fotoelementes, bei dem in getrennten Arbeitsgängen aneinanderliegende Schichten von polykristallinem n-leitfähigem Cadmiumsulfid und polykristallinem p-leitfähigem Cadmiumtellurid nach dem Kleindistanzverfahren aufgedampft werden, dadurch gekennzeichnet, daß mindestens eine der Schichten in Gegenwart von Sauerstoff aufgebracht wird, wodurch sich der Wandler-Wirkungsgrad des Elements erhöht.

2. Verfahren nach Anspruch 1, dadurch gekennzeichnet, daß der Teildruck des Sauerstoffs 1,33 bis 13 000 Pa beträgt.

3. Verfahren nach Anspruch 2, dadurch gekennzeichnet, daß beide getrennten Arbeitsgänge in Gegenwart von Sauerstoff durchgeführt werden.

4. Verfahren nach einem der vorhergehenden Ansprüche, dadurch gekennzeichnet, daß das Cadmiumtellurid auf eine Schicht von Cadmiumsulfid bei einer Temperatur von mindestens 550°C aufgebracht wird.

5. Verfahren nach einem der vorhergehenden Ansprüche, dadurch gekennzeichnet, daß der Teildruck des Sauerstoffs 13,3 bis 1330 Pa beträgt.

6. Verfahren nach Anspruch 5, dadurch gekennzeichnet, daß die Schicht aus Cadmiumsulfid auf eine transparente Unterlage aufgebracht wird.

7. Verfahren nach einem der vorhergehenden Ansprüche, dadurch gekennzeichnet, daß eine oder beide der aufgebrachten Schichten in Gegenwart einer sauerstoffhaltigen Atmosphäre so lange erhitzt werden, bis der Wandler-Wirkungsgrad der so entstandenen Zelle zusätzlich gesteigert worden ist.

8. Dünnschicht-Fotoelement mit einer ersten und einer zweiten Schicht (18, 20), wobei diese Schichten aneinanderliegen und polykristallines p-leitfähiges Cadmiumtellurid bzw. polykristallines n-leitfähiges Cadmiumsulfid enthalten, sowie mit Elektroden (12, 22), die mit diesen Schichten in einer wirksamen niederohmigen Verbindung stehen, dadurch gekennzeichnet, daß bei einer Gesamtdicke der Schichten von höchstens 10 Mirkron mindestens eine der Elektroden durchlässig ist für sichtbares Licht und daß in mindestens eine der Schichten Sauerstoff in einer solchen Menge eingebracht wird, daß der Wandler-Wirkungsgrad des Fotoelementes mindestens 6% beträgt.

# FIG. 1

FIG. 2